# EUROPEAN PATENT APPLICATION

(11) **EP 4 672 329 A1**
(43) Date of publication of application: **31.12.2025**
(21) Application number: 24184260.8
(22) Date of filing: 25.06.2024
(51) Int. Cl.: H01L 23/495

(54) **A SEMICONDUCTOR PACKAGE**

(71) Applicant: Nexperia B.V., 6534 AB Nijmegen (NL)
(72) Inventor: Mohd Zali, Mohd Rozaini, Seremban (MY); Aranas, Brian, Seremban (MY); Ting, Kow Siew, Seremban (MY); Chaw, Wing Onn, Seremban (MY)
(74) Representative: Pjanovic, Ilija

(57) **Abstract**

A semiconductor package and a method of manufacturing one, as well as a lead frame, wherein the semiconductor package comprises such lead frame at least comprising a die pad mounting portion and a bond clip mounting portion. The lead frame exhibits a longitudinal dimension and a transverse dimension oriented perpendicular to the first longitudinal dimension. The semiconductor package further comprises a semiconductor die having a first die side mounted to the die pad mounting portion and a second die side opposite to the first side, and a bond clip exhibiting a first longitudinal dimension and a second longitudinal dimension oriented perpendicular to the first longitudinal dimension. The bond clip has a first clip portion mounted to the bond clip mounting portion of the lead frame using solder and a second clip portion mounted to the second die side of the semiconductor die, wherein the bond clip mounting portion of the lead frame is provided with alignment features structured to prevent displacement of the bond clip in both the longitudinal and the transverse dimension, and to confine the solder on the bond clip mounting portion.

## Description

### TECHNICAL FIELD

The present disclosure relates to a semiconductor package comprising a lead frame, a semiconductor die, and a bond clip.

### BACKGROUND OF THE DISCLOSURE

In semiconductor package manufacturing semiconductor dies mounted to lead frames need to be connected to isolated electrical terminals on the lead frame in order to operate the semiconductor die. Typically, this is done with bond wires, which are thin conductive wires, therefore having high electrical resistance.

Lower electrical resistance, better thermal performance, and potential higher current capacity can be achieved with bond clips, which are conductive pieces of metal shaped to electrically connect the various pins of the semiconductor die with corresponding lead terminals of the lead frame.

For correct functioning of the final semiconductor package, the position of the bond clip is very important. For instance, positioning of the bond clip on the edge of the semiconductor die can lead to product failure of the semiconductor die, resulting in malfunctioning of the semiconductor package.

In the manufacturing process, the lead frame and the semiconductor dies are typically first coated with solder before the bond clips are positioned at their desired location. However, during the reflow process of the solder the bond clips will start to drift due to the melting and liquefication of the solder.

Accordingly, it is a goal of the present disclosure to provide an improved semiconductor package, wherein the drifting of bond clips during the reflow process is limited improving the quality and the yield of semiconductor packages.

### SUMMARY OF THE DISCLOSURE

A first aspect of the disclosure pertains to a semiconductor package comprising a lead frame at least comprising a die pad mounting portion and a bond clip mounting portion and at least one lead terminal. The lead frame exhibits a longitudinal dimension and a transverse dimension oriented perpendicular to the first longitudinal dimension. The semiconductor package further comprises a semiconductor die having a first die side mounted to the die pad mounting portion and a second die side opposite to the first side, and a bond clip exhibiting a first longitudinal dimension and a second longitudinal dimension oriented perpendicular to the first longitudinal dimension. The bond clip has a first clip portion mounted to the bond clip mounting portion of the lead frame using solder and a second clip portion mounted to the second die side of the semiconductor die, wherein the bond clip mounting portion of the lead frame is provided with alignment features structured to prevent displacement of the bond clip in both the longitudinal and the transverse dimension, and to confine the solder on the bond clip mounting portion.

A semiconductor package arranged with a bond clip has better thermal performance and higher current capacity over traditional bond wires. In these semiconductor packages the semiconductor die is electrically connected to at least one lead terminal of the lead frame by means of the bond clip. To do so, the bond clip electrically and mechanically connects the second die side with the bond clip mounting portion of the lead frame.

Furthermore, a semiconductor package having alignment features on the bond clip mounting portion of the lead frame can limit the range of motion of the bond clip during any reflowing of solder. With this configuration it can be assured that both the bond clip and the solder are confined. Namely, the alignment features may be provided such that they ensure that both translational and rotational movements are confined.

According to a first example of the disclosure, the alignment features comprise a first protrusion on the bond clip mounting portion extending along a longitudinal side edge of the bond clip mounting portion and a second protrusion on the bond clip mounting portion extending along a transverse side edge of the bond clip mounting portion.

A semiconductor package configured with two protrusions extending along and positioned on two perpendicular sides of the bond clip mounting portion allows for mechanically containing and aligning the bond clip against both protrusions. The bond clip is intended to rest against both protrusions, such that they function as a sturdy barricade for both the bond clip and the solder. Specifically, this configuration provides a corner into which not only the bond clip can be positioned and oriented, but also the solder can be contained and confined upon reflow. Herewith, the potential movement and solder loss can be mitigated.

In another related example the alignment features further comprise a third protrusion on the bond clip mounting portion positioned opposite to the second protrusion extending along the opposite longitudinal side edge of the bond clip mounting portion.

In a configuration with three protrusions positioned on and extending along three sides (the two longitudinal and one transverse dimension) of the bond clip mounting portion of the lead frame a half-open cup-like feature is formed into which both the bond clip and the solder can be confined and contained, respectively. This particular configuration ensures greater restriction of translational and rotational movements of the bond clip, and can even contain liquified solder.

In yet another example, the alignment features comprise a first protrusion on the bond clip mounting portion extending along a longitudinal side edge of the bond clip mounting portion and at least one notch in the bond clip mounting portion extending along a direction in the transverse dimension.

In this alternative configuration, the translational and rotational movement of the bond clip are constrained by one protrusion and one notch. The notch is indented to accept the bond clip and the bond clip is intended to be rested against the protrusion. Since both are oriented perpendicularly to each other, they restrict movement in both XY as well as rotation of the bond clip. Additionally, the presence of a notch ensures that there is a hollow for solder to collect into upon reflow. This way, the bond clip's movement is restricted, and the solder is confined.

In a related example, the alignment features further comprise a second protrusion on the bond clip mounting portion positioned opposite to the first protrusion extending along the opposite longitudinal side edge of the bond clip mounting portion.

In this configuration the two protrusions hem-in or enclose the at least one notch and the bond clip. Similarly to the previous example, the at least one notch provides a hollow for solder to be contained into upon reflow as well as containing the bond clip to restrict its movement in a direction of both the longitudinal and transverse dimension of the lead frame. This time, the two oppositely placed protrusions on the longitudinal side edges of the bond clip ensure greater entrapment of the translational and rotational movement of the bond clip.

In a further related example, the alignment features even further comprise a third protrusion on the bond clip mounting portion positioned along a transverse edge of the bond clip mounting portion.

In this configuration, both a notch and a half-open cup-like feature, formed by the three protrusions, confine the bond clip and contain the solder. The inclusion of the bond clip and the solder from three sides with an additional hollow for solder to flow into upon reflow ensure that the bond clip's translational and rotational movements are confined, and that the solder is contained.

In a further example, the first protrusion, second protrusion and third protrusion form a conjoined protrusion surrounding an outer periphery of the bond clip mounting portion, in particular the outer periphery extending along both longitudinal and transverse dimension of the lead frame.

By conjoining the three protrusions it is ensured that there are no potential openings for solder to flow through in between any of the protrusions, such that solder cannot flow away from the bond clip mounting portion of the lead frame. This way, the solder containing properties of these particular alignment features can be assured.

In another example, the bond clip has a structure substantially conformal to the dimension of the at least one notch.

To achieve a better latching effect between the bond clip and the notch, the bond clip itself may also be shaped to have more volume fit into the notch. For instance, the second clip portion of the bond clip may even comprise a protrusion which fits snug into the notch. Alternatively, the second part of the bond clip may be shaped as a V, such that the tip of the V fits into the notch. In either case, the bond clip is shaped to take-up the most volume in the notch.

A second aspect of the disclosure pertains to a lead frame comprising any of the alignment features as discussed above.

A third aspect of the disclosure pertains to a method for manufacturing a semiconductor package, comprising the steps of:
i) providing a lead frame exhibiting a longitudinal dimension and a transverse dimension oriented perpendicular to the longitudinal dimension;
ii) forming at least a die pad mounting portion and a bond clip mounting portion in the lead frame, wherein the bond clip mounting portion of the lead frame is provided with alignment features as defined in this disclosure;
iii) providing a semiconductor die having a first die side mounted to the die pad mounting portion and a second die side opposite to the first side;
iv) providing a bond clip having a first clip portion mounted to the bond clip mounting portion of the lead frame using solder and a second clip portion mounted to the second die side of the semiconductor die, wherein the alignment features on the bond clip mounting portion are structured to prevent displacement of the bond clip in both the longitudinal and the transverse dimension, and to confine the solder on the bond clip mounting portion.

Such a method provides a way of manufacturing a semiconductor package having a better thermal performance and a higher current capacity over traditional bond wires. Additionally, the method provides a way of manufacturing a semiconductor package having alignment features on the bond clip mounting portion of the lead frame, which limit the translational and rotational range of motion of the bond clip upon reflowing of solder. With this configuration it can be assured that both the bond clip and the solder are confined.

In a first example of the method, providing the bond clip mounting portion of the lead frame with alignment features in step ii) is performed by stamping.

In an alternative example, providing the bond clip mounting portion of the lead frame with alignment features in step ii) is performed by bending.

The above two examples provide illustrations of how the alignment features may be formed. The exact method of forming the alignment features depends on the lead frame that is being used and the desired resolutions in the dimensions of the alignment features. For instance stamping may be used to form alignment features with high precision in XY, but a dimension of the alignment features perpendicular to the lead frame is only limited to be less than the thickness of the lead frame. Namely, more material is unavailable for stamping. Whereas greater Z dimensions of the alignment features can be obtained through bending. However in those cases, the XY-resolution especially close to the bend, might not be very precise.

In yet another example, the method further comprises a step ii_{b}) after step ii) and before step iii), wherein the alignment features comprise at least one notch in the bond clip mounting portion along a direction in the transverse dimension.

This method provides a way of manufacturing a semiconductor package that has at least one notch as part of the alignment features. The at least one notch offers a latching element for the bond clip to latch onto. Furthermore, the at least one notch also provides a hollow for solder to collect into upon reflow. This way the electrical and mechanical connection as well as the correct position of the bond clip can be assured, since the solder can be confined, and potential translational and rotational movements of the bond clip can be restricted.

In an example of the method step ii_{b}) the at least one notch in the bond clip mounting portion is formed by stamping.

In an alternative example, step ii_{b}) the at least one notch in the bond clip mounting portion is formed by milling.

These two approaches of forming at least one notch are two illustrations to obtain sharp-edged notches. For example, the stamping may offer small and precise notches without the production of dust or particulate, which could contaminate the semiconductor package leading to malfunctioning. Whereas milling may offer deeper and wider notches without deforming the lead frame. Whether to utilize one or both approaches depends on the specific application of the semiconductor package and its dimensions, such as the dimensions of the at least one notch, the dimensions of the lead frame, the dimensions of the semiconductor die, and the dimensions of the bond clip.

All in all, this semiconductor package, the lead frame, and the method for manufacturing them, offer a semiconductor package wherein the bond clip is restricted in its rotational and translational motion, such that the bond clip position will not change drastically during the reflow process of the solder. This way, it can be circumvented that the bond clip comes too close to the edges of the semiconductor die, leading to product failure.

### BRIEF DESCRIPTION OF THE DRAWINGS

The disclosure will now be discussed with reference to the drawings, which show in:
Figure 1 shows a 3D representation of a semiconductor package with a bond clip known in the technical field.
Figure 2 shows an exemplary 3D representation of a semiconductor package with a bond clip according to the disclosure.
Figure 3 shows another exemplary 3D representation of a semiconductor package with alignment features for a bond clip according to the disclosure.
Figure 4 shows yet another exemplary 3D representation of a semiconductor package with alignment features for a bond clip according to the disclosure.
Figure 5 shows yet another exemplary 3D representation of a semiconductor package with alignment features for a bond clip according to the disclosure.
Figure 6 shows yet another exemplary 3D representation of a semiconductor package with alignment features for a bond clip according to the disclosure.
Figures 7A-B show side views of two semiconductors packages with alignment features for bond clips according to the disclosure.

### DETAILED DESCRIPTION OF THE DISCLOSURE

For a proper understanding of the disclosure, in the detailed description below corresponding elements or parts of the disclosure will be denoted with identical reference numerals as in the drawings.

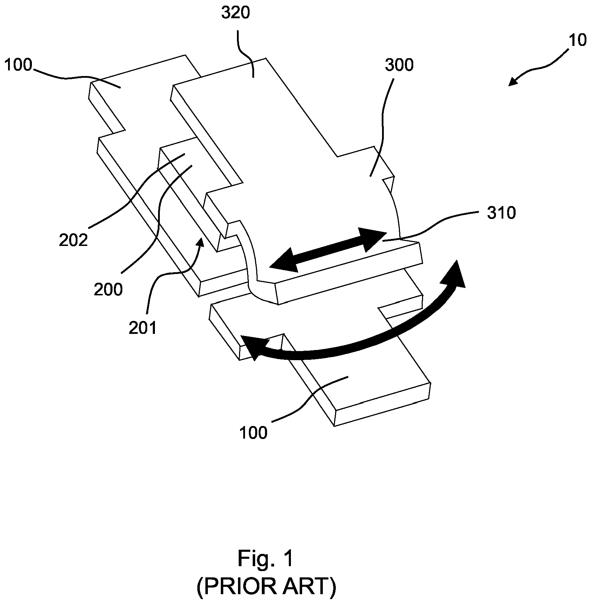

Figure 1 depict a 3D representation of a semiconductor package 10 known in the art, comprising a lead frame 100 having a die pad mounting portion 110 and a semiconductor die 200 having a first side 201 mounted to the mounting pad and a second side 202 opposite to the first side 201. The semiconductor package 10 further comprises a bond clip 300 having a first clip portion 310 mounted to the lead frame 100 and a second clip portion 320 mounted to the second side 202 of the semiconductor die 200.

These semiconductor packages 10 are manufactured by coating the lead frame 100 with solder prior to attaching the semiconductor die 200. Upon reflow of the solder, the solder melts and liquifies. This causes the bond clip 300 to drift on the liquified solder away from its intended position. As shown in Figure 1, this drifting may be rotational and/or translational (in both longitudinal and transverse dimension of the lead frame 100) and causes the bond clip 300 to reposition the second clip portion 320 close to, onto, or even over a side edge 200a of the semiconductor die 200, which could lead to product failure of the semiconductor die 200.

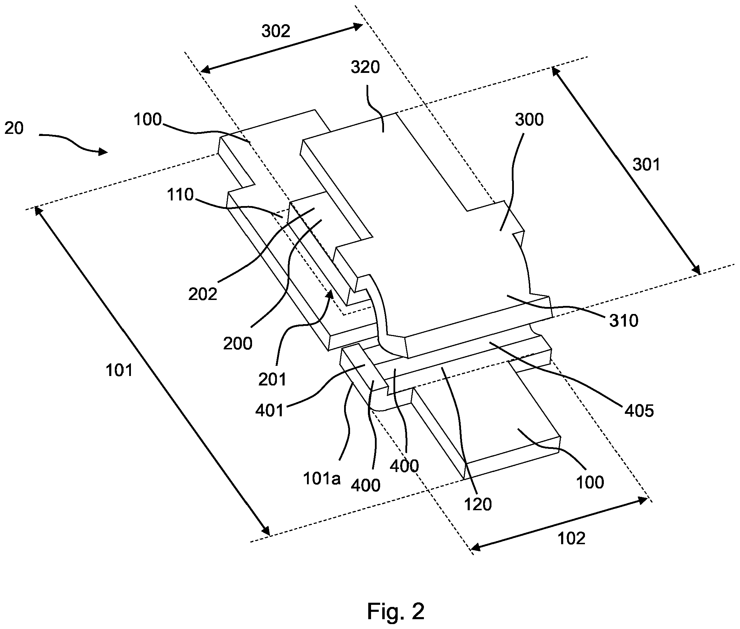

This disclosure aims at resolving these issues by providing a semiconductor package 20, a novel lead frame 100, and a method of manufacturing such semiconductor package 20 comprising such lead frame 100. As shown in Figure 2, the lead frame 100 at least comprises a die pad mounting portion 110 and a bond clip mounting portion 120, and the lead frame exhibits a longitudinal dimension 101 and a transverse dimension 102 oriented perpendicular to the longitudinal dimension 101. The semiconductor package 20 comprises a semiconductor die 200 having a first die side 201 mounted to the die pad mounting portion 110 and a second die side 202 opposite to the first side 201. The semiconductor package 20 further comprises a bond clip 300 exhibiting a first longitudinal dimension 301 and a second longitudinal dimension 302 oriented perpendicular to the first longitudinal dimension 301. The bond clip 300 has a first clip portion 310 mounted to the bond clip mounting portion 120 of the lead frame 100 using solder and a second clip portion 320 mounted to the second die side 202 of the semiconductor die 200.

According to the disclosure a novel lead frame configuration is proposed, wherein the bond clip mounting portion 120 of the lead frame 100 is provided with alignment features 400 structured to prevent displacement of the bond clip 300 in directions of both the longitudinal 301 and the transverse dimension 302, and to confine the solder on the bond clip mounting portion 120. This way, it is prevented that the second clip portion 320 does not come too close to an edge of the semiconductor die 200. Herewith, product failure of the semiconductor die is circumvented, thus resulting in a higher yield and quality of semiconductor packages 20 in the manufacturing process.

This semiconductor package 20 is shown in a first example in Figure 2, wherein the semiconductor package 20 further comprises particular alignment features 400 comprising a first protrusion 401 on the bond clip mounting portion 120 that extends along a longitudinal side edge 101a of bond clip mounting portion 120 (seen along the longitudinal dimension 101 of the lead frame 100), and at least one notch 405 in the bond clip mounting portion 120 that extends along a direction in the transverse dimension 102.

Being provided with a first protrusion 401 along a longitudinal side 101a of the lead frame 100 and along a longitudinal side 301 of the bond clip 300, allows the bond clip 300 of the semiconductor package 20 to be positioned against the first protrusion 401 in a parallel manner. This way the potential movement of the bond clip 300 upon reflow of the solder is already partially restricted in a transverse direction (perpendicular to the longitudinal side 101a and the first protrusion 401.

In a further beneficial example, also shown in Figure 2, the alignment features 400 are further provided with a notch 405 that allows the semiconductor package 20 to have the bond clip 300 latch onto the at least one notch 405 with its first clip portion 310, when movement of the bond clip 300 due to liquified solder is induced. The at least one notch 405 notch in the bond clip mounting portion 120 extends along the direction of the transverse dimension 102 of the lead frame thereof. Furthermore, the at least one notch 405 also offers a hollow for solder to collect into, such that it functions not only to contain and hinder unwanted movement of the bond clip 300, but also to contain and confine solder. In combination with the first protrusion 401, this configuration offers both translational as well as rotational movement inhibition of the bond clip 300 and can contain solder during the reflow process.

The bond clip 300 may be formed in its first clip portion 310 as a V-shaped bond clip 300. Thereby, the elongated formed tip of the V-shape is intended to fit or to accommodate into at least one elongated notch 405. Furthermore, to improve the latching of the V-shaped bond clip 300 into the notch 405, the shape of the tip and the shape of the notch 405 might be manufactured such that the shapes are conformal. Such a configuration allows for good latching and great positioning of the bond clip 300.

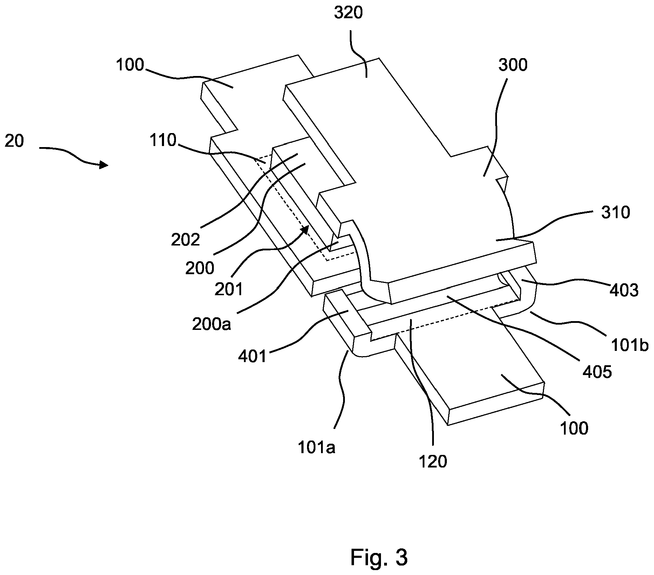

In Figure 3 a second example of a semiconductor package 20 according to the disclosure is shown. In this example, the alignment features 400 of the semiconductor package 20 comprise a further protrusion (third protrusion) 403 on the bond clip mounting portion 120 positioned opposite to the first protrusion 401 along the other opposite longitudinal side edge 101b of the bond clip mounting portion 120.

With this particular configuration, the at least one notch 405 has the same functionality as in the previous example of Figure 2 of offering a latching point for the bond clip 300 to latch onto, and a hollow for solder to collect into upon reflow. Furthermore, this configuration offers greater confinement of the translational and rotational movements of the bond clip 300 due to the presence of the two oppositely placed protrusions 401, 403.

The dimensions of the two protrusions 401, 403 are chosen such that they extend in the direction of the longitudinal dimension 101 of the lead frame 100 and hence can be considered as elongated structured protrusions. Furthermore, the transverse dimension 302 of the bond clip 300 is such that it fits in between the two protrusions 401, 403 with only small tolerances. This way, any rotational movement of the bond clip 300 will cause the bond clip to wedge itself in between the two elongated first and third protrusions 401-403. Furthermore, movement in the direction of the transverse dimension 102 of the lead frame is hindered by the two protrusions 401, 402, and movement in the direction of the longitudinal dimension 101 of the lead frame is hindered by the latching affect of the at least one notch 405.

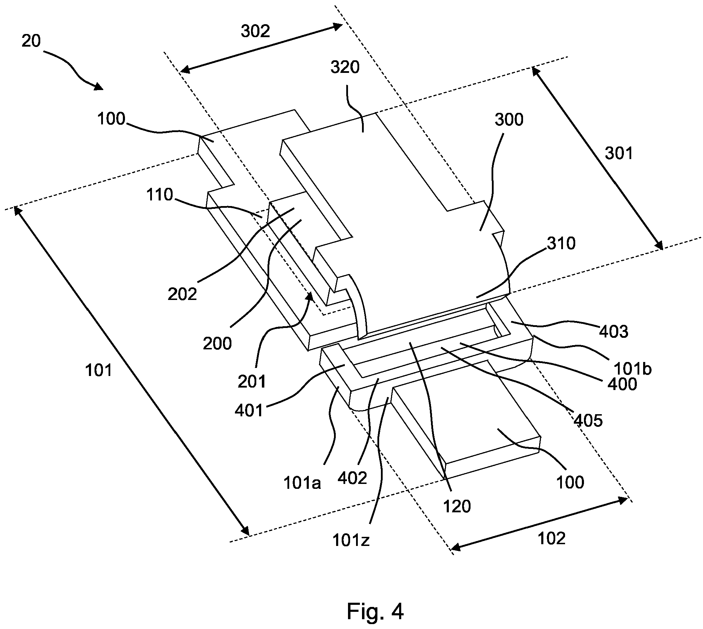

Figure 4 shows a third example of a semiconductor package 20 according to the disclosure, which is based on the second example of a semiconductor package 20, as seen in Figure 3. In this example, the alignment features 400 further comprise a second protrusion 402 on the bond clip mounting portion 120 positioned or extending along a transverse edge 101z of the bond clip mounting portion 120. Additionally, it is shown that the first protrusion 401, second protrusion 402 and third protrusion 403 form a conjoined protrusion surrounding the outer periphery of the bond clip mounting portion 120.

In this configuration, the translational movement of the bond clip 300 is even more restricted compared to the example of the semiconductor package 20 of Figure 3. In this example, movement in the direction of the longitudinal dimension 101 of the lead frame will experience a hard backstop due to the second protrusion 402 in addition to the movement inhibiting latching effect caused by the at least one notch 405.

Additionally, by conjoining all three protrusions 401-402-403 a semi cup-like feature is formed, which further inhibits the loss of solder. Any molten solder can no longer escape from three sides of the bond clip mounting portion 120 of the lead frame 100.

As can be seen in Figure 4, the bond clip 300 has a bend down shape towards the bond clip mounting portion 120, which fits conformally in the at least one notch 405. With the shape of the bond clip 300 being more conformal to the cross-section of the at least one notch 405, the latching effect is greater.

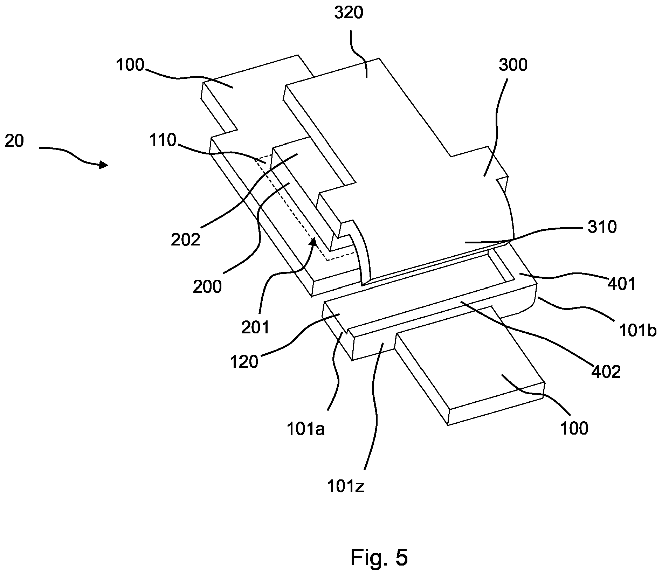

In Figure 5 a fourth example according to the disclosure is shown, wherein the alignment features 400 comprise a first protrusion 401 on the bond clip mounting portion extending along a longitudinal side edge 101b of the bond clip mounting portion 120 and a second protrusion 402 on the bond clip mounting portion extending along a transverse side edge 101z of the bond clip mounting portion 120.

In this configuration having two protrusions 401, 402 on two perpendicular sides 101b-101z of the bond clip mounting portion 120 allows for mechanical confinement of the bond clip 300.The bond clip can be rested against both protrusions in the corner-like structure that is formed by the two protrusions 401, 402, such that a sturdy barricade is formed for keeping the bond clip 120 in its intended position and orientation. Additionally, the corner will contain the liquified solder during the reflow process. Herewith, the potential movement of the bond clip 300 and potential solder loss during reflow can also be mitigated.

For even further confinement the alignment features may further comprise a third protrusion 403 on the bond clip mounting portion positioned opposite to the first protrusion 401 along the other opposite longitudinal side edge 101a of the bond clip mounting portion 120. In that case, the bond clip 300 is enclosed from three sides, inhibiting its motion even more. This example is similar as the example of Figure 4, yet the alignment feature 400 do not incorporate the notch 405.

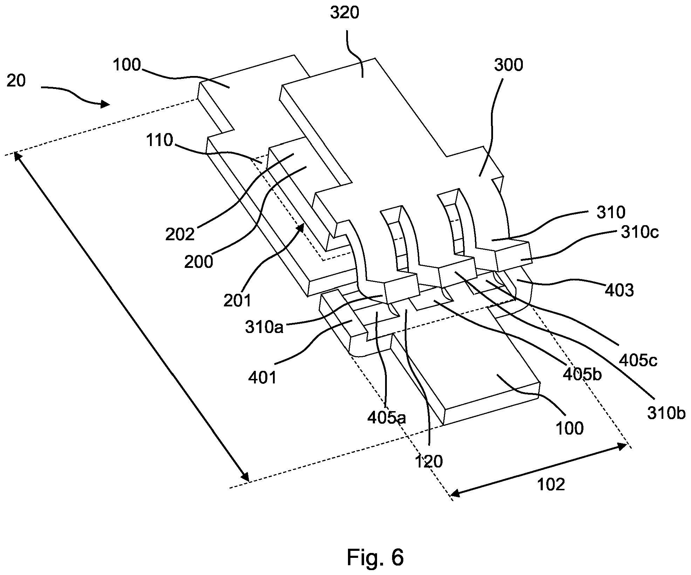

In Figure 6 yet another example of a semiconductor package 20 according to the disclosure is shown, which is somewhat similar to Figure 3. In this figure, the alignment features comprise a first protrusion 401, a further protrusion (third protrusion) 403, and three notches 405a-405b-405c, which are co-aligned along the transverse dimension 102 pf the lead frame. At the same time, the first clip portion 310 of the bond clip 300 is also formed having three end parts 310a-310b-310c extending towards the bond clip mounting portion 120, similar to a fork, wherein each tooth/part fits 310a-310b-310c in one of the three co-aligned notches 405a-405b-405c.

These notches 405a-405b-405c could be positioned side-by-side or co-aligned as shown in Figure 6, but alternatively they could be positioned with longitudinal offsets seen in the longitudinal dimension 101 with respect to each other, with the end parts 310a-310b-310c of the bond clip 300 having a corresponding extended offset in the longitudinal dimension 101 of the lead frame. In the latter case, such configuration could offer more rotational stability for the bond clip 300.

In this configuration, potential movement of the bond clip 300 is restricted due to the three notches 405a-405b-405c and the two oppositely positioned protrusions 401, 403. In this particular configuration, the sides of the notches also act as restrictors of the motion of the bond clip 300. To have an even greater effect the unnotched parts of the bond clip mounting portion 120 may even be provided with additional protrusions that would fit in between the teeth of the forked bond clip 300. Alternatively, the fork may also act as an open space for solder to collect into, such that it does not flow away from the bond clip mounting portion 120 upon reflow.

It should be noted that, even though not explicitly shown in the previous figures, the protrusions do not need to be conjoined. A skilled person in the art understands that conjoining might help to contain solder, but openings between the individual protrusions 401, 402, 403 that are smaller than the capillary length of molten solder still achieve the same effect of containing the molten solder. However, the openings are not limited to be smaller than the capillary length of molten solder.

Not conjoining the protrusions could have manufacturing benefits, such as that they can be formed by bending or could save lead frame material, and thus reduces the costs of the overall semiconductor package 20. Additionally, not conjoining does not bring any disadvantage to the mechanical stability of the alignment features 400 and their ability of confining the bond clip 300.

The protrusions 401, 402, 403 can be manufactured by a stamping or a bending process. These two approaches of forming the protrusion 401, 402, 403 have different utility based on the desired dimensions of the protrusions 401, 402, 403, the actual dimensions of the lead frame 100, the semiconductor die 200, and the bond clip 300. For instance, the stamping of the at least two protrusion may offer sharper corners and edges, which would be beneficial since tolerances may be tighter. Whereas forming the protrusions by bending, longer and thicker protrusions could be formed.

The at least one notch 405 may be formed by two different methods as well: namely, stamping or milling. Stamping, for instance, may offer small and precise notches without the production of dust or particulate. Milling on the other hand may offer deeper and wider notches 405 without deforming the lead frame 100. The application of either method, depends on the application of the semiconductor package 20 and its desired dimensions, as well as the dimensions of the at least one notch 405, the lead frame 100, the semiconductor die 200, and the bond clip 300.

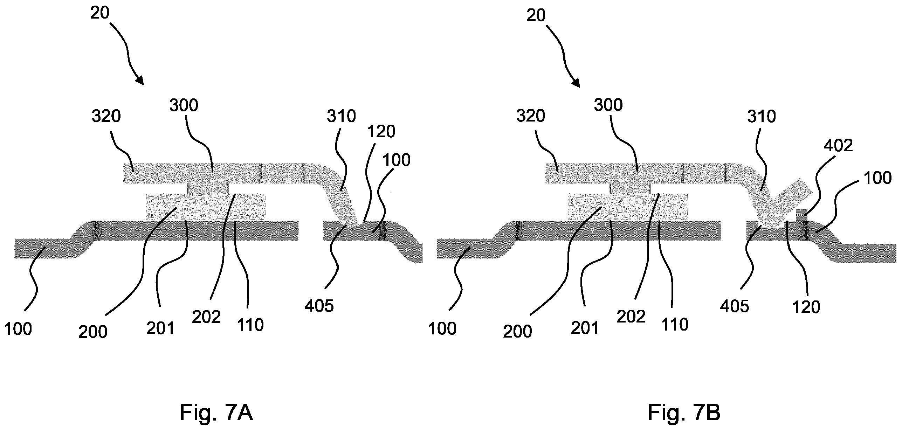

Lastly, in Figure 7A and Figure 7B two cross-sections of semiconductor packages 20 along the longitudinal dimension 101 are shown.

In Figure 7A, the bond clip mounting portion 120 of the lead frame 100 is provided with at least one notch 405, wherein the first clip portion 310 of the bond clip 300 fits conformally. The bond clip 300, in particular, is formed such that its first clip portion 310 is bend towards the at least one notch 405. This way, during reflow of solder a solid mechanical and electrical connection between the lead frame 100 and the bond clip 300 can be formed, especially in a way that solder will be confined by the at least one notch 405.

In Figure 7B, the bond clip mounting portion 120 of the lead frame 100 is provided with a notch 405, which has a rectangular shape. Furthermore, the bond clip mounting portion 120 is provided with a protrusion (second protrusion) 402 along the transverse side edge of the bond clip mounting portion 120. Additionally, the first clip portion 310 of the bond clip 300 is formed as a V-shaped bond clip 300, which would be intended to fit with the tip of the V-shape in the at least one notch 405. This time, the bond clip 300 and the notch 405 are not shape conformal, thereby creating additional space in the notch for solder to collect into. The additional solder might help forming a stable mechanical and electrical connection between the lead frame 100 and the bond clip 300, and also allows for more volume of liquified solder to flow into, such that the solder can be contained during reflow.

It should be clear for the person skilled in the art that the specific examples given in the figures have highlighted features and that these may be added or removed based on the specific requirements of the semiconductor package 20.

All in all, the semiconductor package 20, the lead frame 100, and the method according to the disclosure, provide a way to restrict a bond clip 300 in its rotational and translational motion, such that the bond clip's 300 position will not change drastically during the reflow process of the solder. This way, it can be circumvented that the bond clip 300 comes too close to the edges of the semiconductor die 200, such that the yield and the quality of the semiconductor packages 20 is improved.

### LIST OF REFERENCE NUMERALS USED

- 10: prior art semiconductor package
- 20: semiconductor package according to the disclosure
- 100: lead frame
- 101: longitudinal dimension of the lead frame
- 101a-101b: longitudinal side edges of the lead frame
- 101z: transverse side edge of the lead frame
- 102: transverse dimension of the lead frame
- 110: die pad mounting portion
- 120: bond clip mounting portion
- 200: a semiconductor die
- 200a: side edge of the semiconductor die
- 201: a first die side
- 202: a second die side
- 300: a bond clip
- 301: longitudinal dimension of bond clip
- 302: transverse dimension of bond clip
- 310: first clip portion
- 310a-310b-310c: end parts of first clip portion
- 320: second clip portion
- 400: alignment features
- 401: first protrusion
- 402: second protrusion
- 403: third protrusion
- 405: at least one notch
- 405a-405b-405c: first, second, third notch

## Claims

1. A semiconductor package comprising:
- a lead frame at least comprising a die pad mounting portion and a bond clip mounting portion, the lead frame exhibiting a longitudinal dimension and a transverse dimension oriented perpendicular to the longitudinal dimension;
- a semiconductor die having a first die side mounted to the die pad mounting portion and a second die side opposite to the first side;
- a bond clip exhibiting a first longitudinal dimension and a second longitudinal dimension oriented perpendicular to the first longitudinal dimension, the bond clip having a first clip portion mounted to the bond clip mounting portion of the lead frame using solder and a second clip portion mounted to the second die side of the semiconductor die, wherein the bond clip mounting portion of the lead frame is provided with alignment features structured to prevent displacement of the bond clip in a direction of the longitudinal and/or the transverse dimension of the lead frame, and to confine the solder on the bond clip mounting portion.

2. A semiconductor package according to claim 1, wherein the alignment features comprise a first protrusion on the bond clip mounting portion extending along a longitudinal side edge of bond clip mounting portion and a second protrusion on the bond clip mounting portion extending along a transverse side edge of the bond clip mounting portion.

3. A semiconductor package according to claim 2, wherein the alignment features further comprise a third protrusion on the bond clip mounting portion positioned opposite to the first protrusion extending along the opposite longitudinal side edge of the bond clip mounting portion.

4. A semiconductor package according to claim 1, wherein the alignment features comprise a first protrusion on the bond clip mounting portion extending along a longitudinal side edge of the bond clip mounting portion and at least one notch in the bond clip mounting portion extending along the direction of the transverse dimension.

5. A semiconductor package according to claim 4, wherein the alignment features further comprise a third protrusion on the bond clip mounting portion positioned opposite to the first protrusion extending along the opposite longitudinal side edge of the bond clip mounting portion.

6. A semiconductor package according to claim 5, wherein the alignment features even further comprise a second protrusion on the bond clip mounting portion positioned along a transverse edge of the bond clip mounting portion.

7. A semiconductor package according to claim 3 or claim 6, wherein the first protrusion, second protrusion and third protrusion form a conjoined protrusion surrounding an outer periphery of the bond clip mounting portion.

8. A semiconductor package according to any of the claims 4-6, wherein the bond clip has a structure substantially conformal to the dimension of the at least one notch.

9. A lead frame comprising the alignment features according to any of the preceding claims.

10. A method for manufacturing a semiconductor package according to any of the previous claims, comprising the steps of:
i) providing a lead frame exhibiting a longitudinal dimension and a transverse dimension oriented perpendicular to the longitudinal dimension;
ii) forming at least a die pad mounting portion and a bond clip mounting portion in the lead frame, wherein the bond clip mounting portion of the lead frame is provided with alignment features as defined in any one or more of the claims 1-8;
iii) providing a semiconductor die having a first die side mounted to the die pad mounting portion and a second die side opposite to the first side;
iv) providing a bond clip having a first clip portion mounted to the bond clip mounting portion of the lead frame using solder and a second clip portion mounted to the second die side of the semiconductor die, wherein the alignment features on the bond clip mounting portion are structured to prevent displacement of the bond clip in both the longitudinal and the transverse dimension, and to confine the solder on the bond clip mounting portion.

11. The method for manufacturing a semiconductor package according to claim 10, wherein providing the bond clip mounting portion of the lead frame with alignment features in step ii) is performed by stamping.

12. The method for manufacturing a semiconductor package according to claim 10, wherein providing the bond clip mounting portion of the lead frame with alignment features in step ii) is performed by bending.

13. The method of manufacturing a semiconductor package according to claim 10 dependent on any of the claims 4-6, further comprising a step ii_{b}) after step ii) and before step iii), wherein the alignment features comprise at least one notch in the bond clip mounting portion along a direction in the transverse dimension.

14. The method of manufacturing a semiconductor package according to claim 13, wherein step ii_{b}) the at least one notch in the bond clip mounting portion is formed by stamping.

15. The method of manufacturing a semiconductor package according to claim 13, wherein step ii_{b}) the at least one notch in the bond clip mounting portion is formed by milling.
